Europäisches Patentamt

(19) European Patent Office

Office européen des brevets

(11) Numéro de publication : **0 263 755 B1**

(12) # FASCICULE DE BREVET EUROPEEN

(45) Date de publication du fascicule du brevet :
**05.06.91 Bulletin 91/23**

(51) Int. Cl.⁵ : **H01L 29/90, H01L 29/72, H01L 21/324**

(21) Numéro de dépôt : **87402202.3**

(22) Date de dépôt : **05.10.87**

(54) **Procédé de fabrication d'une diode P+NN+ et d'un transistor bipolaire comportant cette diode, utilisant l'effet de neutralisation des atomes donneurs par l'hydrogène atomique.**

(30) Priorité : **06.10.86 FR 8613885**

(43) Date de publication de la demande :
**13.04.88 Bulletin 88/15**

(45) Mention de la délivrance du brevet :
**05.06.91 Bulletin 91/23**

(84) Etats contractants désignés :
**DE GB IT NL**

(56) Documents cités :
**EP-A- 0 081 414**
**EP-A- 0 184 016**
**JOURNAL OF APPLIED PHYSICS, vol. 59, no. 11, 1er juin 1986, pages 3774-3777, American Institute of Physics, New York, US; A. JALIL et al.: "Electron mobility studies of the donor neutralization by atomic hydrogen in GaAs doped with silicon"**
**IEEE ELECTRON DEVICE LETTERS, vol. EDL-5, no. 8, août 1984, pages 310-312, IEEE, New York, US; P.M. ASBECK et al.: "GaAs/(Ga,Al)As heterojunction bipolar transistors with buried oxygen-implanted isolation layers"**

(56) Documents cités :
**GaAs IC SYMPOSIUM - TECHNICAL DIGEST 1985, Monterey, California, 12-14 novembre 1985, pages 53-56, IEEE; T. OHSHIMA et al.: "A self-aligned GaAS/AlGaAs heterojunction bipolar transistor with V-groove isolated planar structure"**

(73) Titulaire : **CENTRE NATIONAL DE LA RECHERCHE SCIENTIFIQUE (CNRS)**
**15, Quai Anatole France**
**F-75700 Paris Cedex 07 (FR)**
Titulaire : **ETAT FRANCAIS représenté par le Ministre des PTT (Centre National d'Etudes des Télécommunications)**
**38-40 rue du Général Leclerc**
**F-92131 Issy-les-Moulineaux (FR)**

(72) Inventeur : **Mircea, Andrei**
**31, rue Frédéric Mistral**
**F-91330 Yerres (FR)**
Inventeur : **Chevallier, Jacques**
**26, rue des Iles Glénans**
**F-78310 Maurepas (FR)**

(74) Mandataire : **Mongrédien, André et al**
**c/o BREVATOME 25, rue de Ponthieu**
**F-75008 Paris (FR)**

# Description

La présente invention a pour objet la fabrication d'une diode $p^+nn^+$ dans un substrat en matériau III-V utilisant l'effet de neutralisation de donneurs par l'hydrogène atomique.

Elle s'applique en particulier dans le domaine de la fabrication de composants semi-conducteurs ultra-rapides destinés à la micro-électronique et aux hyperfréquences et plus particulièrement dans le domaine des transistors bipolaires homojonction ou à hétérojonction utilisables principalement en télémétrie, en optique intégrée ou dans les télécommunications par fibres optiques. Dans ces transistors bipolaires la diode $p^+nn^+$ constitue l'émetteur et la base.

De façon plus précise, l'invention a trait à la fabrication d'une diode latérale $p^+nn^+$ ayant des dimensions extrêmement réduites. Une diode latérale est une diode dont les régions $p^+nn^+$ sont alignées dans un même plan, parallèle à la surface du substrat.

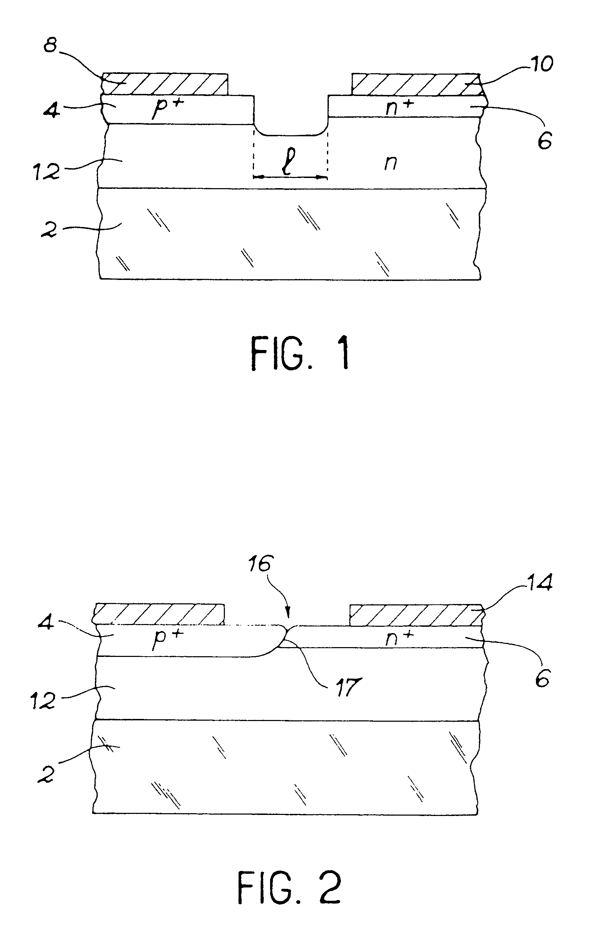

Sur la figure 1, on a représenté schématiquement en coupe longitudinale, une diode latérale en matériau III-V. Cette diode comporte à la surface d'un substrat 2 en matériau semi-isolant III-V de type n une région 4 de type $p^+$ et une région 6 de type $n^+$ surmontée chacune d'un contact métallique respectivement 8 et 10.

Les deux régions de type $p^+$ et $n^+$ diffusées ou implantées dans le substrat 2 sont séparées par une région moins conductrice 12, généralement de type n ou p, mais non pas forcément isolante, de longueur l très faible (de l'ordre de 1 à 10 micromètres) mais non nulle.

En effet, si cette longueur l est trop grande, le temps de commutation de la diode augmente, la diffusion des porteurs dans cette région se faisant sur une trop grande distance. D'autre part, si cette distance l est nulle la caractéristique courant-tension de la diode est dégradée, car le courant peut passer également et facilement dans les deux sens, par effet Tunnel.

Le procédé de fabrication d'une diode $p^+nn^+$ de l'art antérieur est illustré de façon schématique sur la figure 2.

Actuellement, la région 12 de type n de la diode est réalisée par épitaxie sur le substrat 2 en matériau III-V et la région 6 de type $n^+$ est aussi réalisée par épitaxie ou éventuellement par implantation ionique dans la couche 12 de type n. Le niveau de dopage actif maximum utilisé pour la région 6 de type $n^+$ se situe entre 1 et $5 \cdot 10^{18}$ at/cm$^3$.

La région 4 de type $p^+$ est ensuite réalisée par implantation ionique, avec un niveau de dopage actif généralement supérieur à $10^{19}$ at/cm$^3$, dépassant donc largement celui de la région 6 de type $n^+$.

A ce stade de la fabrication, les régions 4 et 6 sont adjacentes comme le montre la figure 2. Par conséquent, la caractéristique courant-tension est mauvaise.

On effectue alors un masquage partiel de la surface de la structure avec une résine 14 laissant découverte seulement une zone 16 de très faible largeur, alignée et centrée sur le bord 17 de la région implantée 4 de type $p^+$ adjacente à la région $n^+$ 6. On effectue alors un traitement d'attaque de la zone 16 de matériau III-V non masquée par voie humide ou plasma de façon à enlever toute cette région, fortement dopée ($p^+$ ou $n^+$ ou les deux).

Après élimination du masque de résine 14, on réalise les contacts métalliques 8 et 10 sur respectivement les régions de type $p^+$ et $n^+$ de la diode. Pour cela, on fait de nouveau appel à des opérations de masquage définissant l'image des contacts à réaliser, à des dépôts de couche métallique, etc. Lors de ces opérations, il est impératif d'aligner les masques utilisés pour la réalisation des contacts avec le masque 14 utilisé précédemment pour le traitement d'attaque, de manière à ne pas recouvrir de métal la région 16 attaquée mais seulement celles de type $p^+$ et de type $n^+$.

La surface de la diode $p^+nn^+$, résultant de l'attaque chimique ou plasma ci-dessus n'est plus plane, entraînant une difficulté de nettoyage et de passivation ultérieure ainsi que des problèmes d'alignement et de réalisation des contacts métalliques sur les régions $p^+$ et $n^+$ de la diode.

Par ailleurs, il est nécessaire de positionner de manière très précise le masque d'attaque 14 sur la périphérie de la région implantée $p^+$. Ceci entraîne un rendement de fabrication faible et ce, d'autant plus que la région 16 à attaquer doit être très étroite.

En outre, la vitesse d'attaque de cette région fortement dopée doit être calibrée de manière très précise afin d'éviter une attaque en profondeur de la région n sous-jacente, allant jusqu'au substrat 2, conduisant à une diode $p^+nn^+$ risquant de ne plus conduire du tout.

Dans le cas particulier des diodes émetteur-base des transistors bipolaires, le risque est de couper la base du transistor de son contact extérieur.

L'une des techniques utilisées pour réaliser de bonnes jonctions p-n entre base et émetteur d'un transistor bipolaire est notamment décrite dans l'article de D. ANKRI et al. paru dans Physica 129B (1985), p. 361-365, intitulé "Design and fabrication process of GaAs-GaAlAs ECL inverters". Dans ce document, la région $n^+$ de l'émetteur est enlevée par attaque chimique sur toute la surface de la structure, excepté à l'emplacement du contact émetteur.

Cette technique présente de très sérieuses limitations sur le plan de la miniaturisation des transistors compte tenu des problèmes liés au positionnement correct du masque de gravure utilisé pour former la région $n^+$ par rapport aux contacts de la base et de l'émetteur.

Une deuxième technique actuellement utilisée pour réaliser de bonnes jonctions p-n entre base et émetteur d'un transistor bipolaire est décrite dans le document de R.J. MALIK et al., paru dans Appl. Phys. Lett. 46 (6), 15 mars 1985, p. 600-602, intitulé "High gain high frequency AlGaAs/GaAs graded band-gap base bipolar transistors with Be diffusion setback layer in the base".

Cette technique est supérieure à la précédente ; elle consiste à enlever uniquement la région n⁺ située entre l'émetteur et la base. Toutefois, la structure obtenue après l'attaque chimique n'est plus plane, entraînant comme précédemment des difficultés de nettoyage et de passivation ultérieures ainsi que de réalisation de contact métallique sur la base de l'émetteur.

Par ailleurs, il est connu du document Appl. Phys. Lett. 47 (2) du 15 juillet 1985, p. 108-110, intitulé "Donor neutralization in GaAs (Si) by atomic hydrogen" de J. CHEVALLIER et al. de neutraliser du point de vue électrique des atomes donneurs (Si) d'un substrat en GaAs par de l'hydrogène atomique.

La présente invention a justement pour objet un procédé de fabrication d'une diode p⁺ nn⁺ permettant de rémédier aux différents inconvénients ci-dessus en éliminant notamment l'étape d'attaque chimique ou plasma ci-dessus.

De façon plus précise, l'invention a pour objet un procédé de fabrication d'une diode p⁺ nn⁺ dans un substrat semiconducteur en matériau III-V, comportant une région de type p⁺, une région de type n et une région de type n⁺, caractérisé en ce qu'il comprend les étapes suivantes :

  – formation d'une couche en matériau III-V de type n⁺ à la surface du substrat,
  – implantation locale d'ions accepteurs dans la couche en matériau III-V pour former, en surface, la région de type p⁺ de la diode adjacente à une région latérale de type n⁺,
  – réalisation de deux contacts métalliques à la surface de la couche en matériau III-V, situés à proximité l'un de l'autre et respectivement sur la région de type p⁺ et sur la région latérale de type n⁺, une partie de cette région latérale, contiguë à la région de type p⁺, étant dépourvue de contact métallique et l'autre partie de cette région latérale, revêtue d'un contact métallique, correspondant à la région de type n⁺ de la diode, et
  – hydrogénation de la structure pour former une région de type n dans la partie de la région intermédiaire, dépourvue de contact métallique, les contacts métalliques servant de masque à cette hydrogénation.

Par substrat, il faut comprendre aussi bien un substrat massif qu'une couche déposée sur un substrat massif ou sur un empilement de couches.

Le remplacement de l'attaque chimique par une étape d'hydrogénation permet d'obtenir une structure plane facilitant ainsi la réalisation de contacts métalliques des régions de type p⁺ et de type n⁺ de la diode.

Ce traitement d'hydrogénation, comme décrit dans l'article précédent de J. CHEVALLIER permet de neutraliser du point de vue électrique les atomes donneurs de la région n⁺ de sorte que le semi-conducteur devient, dans cette région, de type n au lieu de type n⁺, avec une concentration de porteurs typiquement comprise entre $10^{16}$ et $5 \cdot 10^{16}$ porteurs/cm³ lorsque la concentration initiale de porteurs est de quelques $10^{18}$/cm³.

La région n⁺ protégée par le contact métallique correspondant n'est nullement affectée par cette hydrogénation.

Les inventeurs se sont aperçus de façon surprenante que la neutralisation électrique est différente de la compensation électrique, obtenue généralement par bombardements ioniques (protons par exemple). En effet, la neutralisation électrique conduit à une augmentation de la mobilité des porteurs à l'inverse de la compensation électrique, comme illustré dans le document J. Appl. Phys., vol 59, n° 11 du 1er juin 1986, pp. 3774-3777, de JALIL, CHEVALLIER, AZOULAY et MIRCEA. Cette neutralisation permet donc l'obtention d'une diode fonctionnement rapide.

A l'aide du procédé de l'invention, il se forme, par auto-alignement ou auto-positionnement autour des contacts métalliques des régions n⁺ et p⁺, une région de type n et par conséquent, une diode p⁺nn⁺ qui a les caractéristiques électriques voulues.

En particulier, cet auto-alignement de la région n par rapport aux contacts métalliques des régions p⁺ et n⁺, minimise le temps de commutation de la diode par une optimisation simultanée des résistances en série des régions p⁺, n et n⁺ et de la longueur de diffusion des porteurs dans la région n allant dans le sens de rapidité de fonctionnement de la diode.

Par ailleurs, le procédé de l'invention est facile à mettre en oeuvre. En particulier, les paramètres de l'étape d'hydrogénation et notamment sa durée, ne sont nullement critiques.

De façon avantageuse, l'hydrogénation est réalisée en soumettant la structure à un plasma d'hydrogène.

Selon un premier mode de mise en oeuvre du procédé selon l'invention, on effectue les étapes successives suivantes :
  – formation de la couche en matériau III-V,
  – dépôt d'une couche isolante sur la couche en matériau III-V,
  – formation d'un premier masque en résine sur la couche isolante, ayant une ouverture correspondant à la région de type p⁺ de la diode à réaliser,
  – élimination des régions de la couche isolante non masquées par le premier masque,
  – implantation d'ions accepteurs dans la couche en matériau III-V, utilisant le premier masque de résine, pour former la région de type p⁺ de la diode,

– dépôt d'une première couche métallique sur le premier masque de résine et sur la région de type p⁺,

– élimination du premier masque de résine entraînant l'élimination de la première couche métallique à l'exception du contact métallique de la région de type p⁺ de la diode,

– formation d'un second masque sur la structure obtenue, ayant une ouverture correspondant à la région de type n⁺ de la diode à réaliser,

– élimination de la région de la couche isolante non masquée par le second masque,

– dépôt d'une seconde couche métallique sur le second masque de résine et sur la couche de type n⁺ non recouverte par la couche isolante,

– élimination du second masque de résine entraînant l'élimination de la seconde couche métallique à l'exception du contact métallique de la région de type n⁺ de la diode à réaliser,

– recuit de la structure,

– élimination du restant de la couche isolante, et

– hydrogénation de la structure pour former la région de type n de la diode entre les régions de type p⁺ et de type n⁺ de la diode.

Ce premier mode de mise en oeuvre est utilisable avec des première et seconde couches métalliques en matériau réfractaire, ne subissant aucun dommage lors du recuit de la structure.

Pour la réalisation de contacts métalliques des régions n⁺ et p⁺ de la diode, non réfractaires, on préfère utiliser un second mode de mise en oeuvre du procédé selon l'invention, comprenant les étapes suivantes :

– formation de la couche en matériau III-V,

– dépôt d'une première couche isolante sur la couche en matériau III-V,

– formation d'un premier masque en résine sur la première couche isolante, ayant une ouverture correspond à de la région de type p⁺ de la diode à réaliser,

– élimination des régions de la première couche isolante non masquées par le premier masque,

– implantation d'ions accepteurs dans la couche en matériau III-V, utilisant le premier masque de résine pour former la région de type p⁺ de la diode,

– élimination du premier masque de résine,

– dépôt d'une seconde couche isolante sur la structure obtenue,

– recuit de la structure pour activer électriquement les ions accepteurs implantés,

– formation d'un second masque sur la structure, ayant une ouverture correspondant à la région de type n⁺ de la diode, à réaliser,

– élimination des régions de la première et de la seconde couches isolantes non masquées par le second masque,

– dépôt d'une première couche métallique sur le second masque de résine et sur la couche de type n⁺ non recouverte par les couches isolantes,

– élimination du second masque de résine entraînant l'élimination de la première couche métallique à l'exception du contact métallique de la région de type n⁺ de la diode, à réaliser,

– dépôt d'un troisième masque sur la structure, identique au premier masque,

– élimination des régions de la première et de la seconde couches isolantes non masquées par le troisième masque,

– dépôt d'une seconde couche métallique sur la structure obtenue,

– élimination du troisième masque de résine entraînant l'élimination de la seconde couche métallique à l'exception du contact métallique de la région de type p⁺ de la diode,

– recuit de la structure,

– élimination des restants de la première et de la seconde couches isolantes, et

– hydrogénation de la structure pour former la région de type n de la diode entre les régions de type p⁺ et de type n⁺ de la diode.

La couche en matériau III-V de type n⁺ peut être formée à la surface du substrat, soit par implantation d'ions donneurs tels que des ions de silicium, de sélénium ou de germanium, soit par épitaxie par jet moléculaire ou en phase vapeur.

Afin de permettre une hydrogénation jusqu'au substrat, l'épaisseur de la couche en matériau III-V doit être inférieure à 1 μm.

L'invention s'applique à tout type de matériau III-V. En effet, la couche de type n⁺ et le substrat, qui peuvent être identiques ou différents, peuvent être réalisés en InP, GaAs, GaSb, InAs, InSb, $Ga_{1-x}Al_xAs$, $Ga_{1-x}In_xAs$, $Ga_{1-x}In_xAs_{1-y}P_y$, $Al_{1-x}In_xAs$ ou $Ga_{1-x-y}Al_xIn_yAs$ avec $0<x\leq1$ et $0<y\leq1$.

Le procédé de fabrication de la diode ci-dessus s'applique avantageusement à la réalisation de la diode émetteur-base des transistors bipolaires homo- ou hétérojonction, notamment du type GaAs, GaAs/GaAlAs ou GaInAs/InP.

A cet effet, l'invention a encore pour objet un procédé de fabrication d'un transistor bipolaire en matériau III-V comportant une diode p⁺nn⁺ entre la base et l'émetteur, caractérisé en ce qu'il comprend les étapes suivantes :

– dépôt d'une première couche en matériau III-V de type n sur un substrat en matériau III-V, constituant le collecteur du transistor,

– dépôt d'une seconde couche en matériau III-V de type p sur la première couche en matériau III-V, constituant la base du transistor,

– dépôt d'une troisième couche en matériau III-V de type n sur la seconde couche en matériau III-V, constituant l'émetteur du transistor,

– formation d'une quatrième couche en matériau III-V de type n⁺ à la surface de la troisième couche en matériau III-V, servant de contact électrique à l'émetteur,

– implantation locale d'ions accepteurs dans les quatrièmes et troisième couches en matériau III-V pour former la région de type p⁺ de la diode, adjacente à une région latérale de type n⁺ de la quatrième couche et s'étendant en profondeur jusqu'à la seconde couche en matériau III-V,

– réalisation de deux contacts métalliques à la surface de la quatrième couche en matériau III-V, situés à proximité l'un de l'autre et respectivement sur la région de type p⁺ et sur la région latérale de type n⁺, une partie de cette région latérale, contiguë à la région de type p⁺, étant dépourvue de contact métallique et l'autre partie de cette région latérale, revêtue d'un contact métallique, correspondant à la région de type n⁺ de la diode, et

– hydrogénation de la structure pour former une région de type n dans la partie de la région intermédiaire dépourvue de contact métallique, les contacts métalliques servant de masque à cette hydrogénation.

D'autres caractéristiques et avantages de l'invention ressortiront mieux de la description qui va suivre, donnée à titre illustratif et non limitatif.

La description se réfère aux figures annexées, dans lesquelles :

– la figure 1, déjà décrite, représente schématiquement en coupe longitudinale, une diode p⁺nn⁺ selon l'art antérieur,

– la figure 2, déjà décrite, illustre schématiquement, en coupe longitudinale le procédé de réalisation de la diode p⁺nn⁺ de la figure 1,

– les figures 3 à 7 illustrent, schématiquement en coupe longitudinale, un premier mode de mise en oeuvre du procédé de fabrication selon l'invention,

– les figures 8 à 10 illustrent, schématiquement en coupe longitudinale, un second mode de mise en oeuvre du procédé de fabrication selon l'invention, et

– la figure 11 représente schématiquement, en coupe longitudinale, un transistor bipolaire hétérojonction comportant une diode p⁺nn⁺, réalisée par le procédé selon l'invention, entre la base et l'émetteur.

La description ci-après se réfère à la fabrication d'une diode p⁺nn⁺ réalisée dans un substrat en GaAs. Toutefois, comme on l'a vu précédemment, d'autres substrats en matériau III-V peuvent être envisagés.

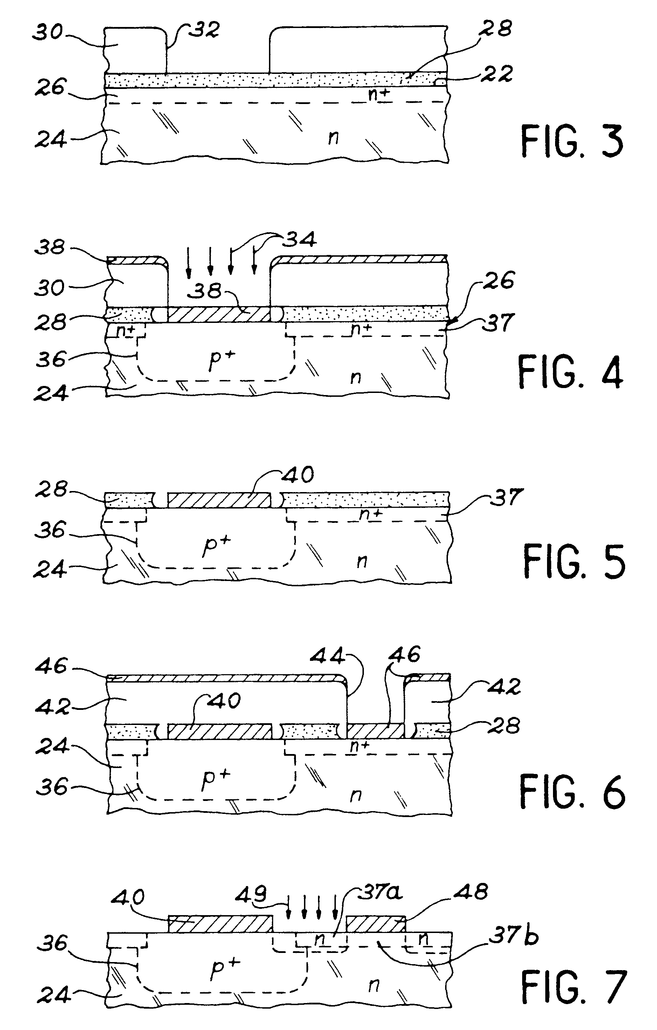

La première étape du procédé consiste à polir chimiquement la surface 22 d'un substrat semi-isolant 24 en GaAs de type n, comme représenté sur la figure 3, par un solvant inorganique tel que $H_2SO_4 + H_2O_2 + H_2O$. Ensuite, on forme à la surface du substrat 24 une couche 26 en GaAs de type n⁺ en implantant des ions donneurs à la surface dudit substrat. Cette implantation est réalisée en particulier avec des ions de silicium à une dose de $5 \cdot 10^{14}$ at/cm² et une énergie de 190 keV pour former une couche 26 de type n⁺, d'une épaisseur de l'ordre de 200 nm.

On effectue ensuite un recuit de la structure afin d'activer électriquement les ions donneurs implantés. Ce recuit est réalisé en particulier 850°C pendant 30 minutes en atmosphère d'arsine.

Bien entendu, il est possible de remplacer les étapes de polissage, d'implantation et de recuit par une épitaxie par jet moléculaire ou en phase vapeur d'une couche de GaAs de type n⁺ à la surface 22 du substrat 24, de 200 nm.

A la surface de la couche 26 de type n⁺, on dépose ensuite par la technique de dépôt chimique en phase vapeur assistée plasma (PECVD) une couche isolante 28 de 200 nm environ. Cette couche isolante peut être réalisée en nitrure de silicium ($Si_3N_4$) ou en oxyde de silicium ($SiO_2$).

Sur la couche isolante 28, on forme alors par les procédés classiques de photolithographie, un masque de résine 30 représentant l'image de la région de type p⁺ de la diode à réaliser. En particulier, ce masque de résine 30 comporte une ouverture 32.

A travers ce masque de résine 30, on réalise une gravure, comme représenté sur la figure 4, de la couche isolante 28 consistant à éliminer la région de cette couche non masquée. Cette gravure peut être réalisée de façon isotrope par une gravure plasma utilisant comme agent d'attaque du $CF_4$ ou $CHF_3$ ou par attaque chimique en utilisant une solution tamponnée d'acide fluorhydrique.

On réalise alors une implantation ionique 34 d'ions accepteurs dans les régions de la couche 26 de type n⁺ et du substrat 24 non recouvertes d'isolant 28 et de résine 30. Cette implantation ionique permet d'obtenir une région 36 de type p⁺, adjacente à une région de type n⁺ 37, dite région latérale, et centrée par rapport à l'ouverture 32 du masque de résine 30.

Cette implantation est réalisée avec des ions Mg⁺ à une dose de $9 \cdot 10^{14}$ at/cm² et une énergie de 350 keV conduisant l'obtention d'une région 36 d'environ 500 nm d'épaisseur. Cette implantation ionique peut être suivie d'une seconde implantation d'ions Mg⁺ à une dose de $6 \cdot 10^{13}$ at/cm² et une énergie de 30 KeV, assurant ainsi une bonne conductivité électrique en surface de la région 36.

L'étape suivante du procédé consiste à déposer sur la structure, c'est-à-dire sur le masque 30 et la région 36 de type p⁺, une première couche conductrice 38 d'environ 300 nm. Cette couche 38 est réalisée en matériau réfractaire tel qu'un matériau multicouche de titane et d'or déposé par évaporation sous vide.

On élimine ensuite le masque de résine 30, par dissolution dans une cétone, entraînant ainsi l'élimination du matériau conducteur 38 surmontant la résine. Cette technique est connue sous le nom de "lift off". La structure obtenue est celle représentée sur la figure 5.

Sur cette figure, le contact métallique de la région 36 de type p$^+$ obtenu porte la référence 40. Il est auto-positionné sur la région p$^+$ étant donné que le contact métallique 40 et la zone implantée p$^+$ sont réalisés en utilisant le même masque de résine 30.

L'étape suivante du procédé consiste à réaliser un second masque de résine 42, comme représenté sur la figure 6, représentant l'image de la région de type n$^+$ de la diode à réaliser. A cet effet, ce masque de résine 42, réalisé selon les procédés classiques de photolithographie, comporte une ouverture 44.

Ensuite, on élimine les régions de la couche isolante 28 non recouvertes par la résine 42. Ceci se fait par gravure plasma isotrope en utilisant comme agent d'attaque du CF$_4$ ou CHF$_3$ ou par attaque chimique avec une solution tamponnée d'acide fluorhydrique.

Sur le masque de la résine 42 et la région de type n$^+$ de la diode à réaliser, on dépose alors par évaporation sous vide une seconde couche conductrice 46. Cette couche 46 est réalisée en matériau réfractaire et en particulier en un matériau multicouche de germanium, molybdène, titane et or. Cette couche 46 présente une épaisseur de l'ordre de 300 nm.

On élimine ensuite le second masque de résine 42 par dissolution dans une cétone afin de conduire, par "lift off", à l'obtention d'un contact métallique 48 de la région de type n$^+$ à réaliser, comme représenté sur la figure 7.

On effectue ensuite un recuit thermique de la structure pendant environ 30 minutes sous arsine à 800°C afin de former les alliages des contacts métalliques 40 et 48 des régions de type p$^+$ et n$^+$ de la diode, réalisant ainsi des contacts ohmiques, et d'activer électriquement les ions accepteurs implantés pour former la région 36 de type p$^+$.

On élimine ensuite le restant de la couche isolante 28, comme représenté sur la figure 7 par attaque chimique avec une solution de HF tamponnée.

La dernière étape du procédé consiste à soumettre la structure obtenue à l'action d'un plasma d'hydrogène 49 pendant 1/2 à 1 heure conduisant à la formation d'une région de type n 37a non recouverte de contact métallique et auto-alignée par rapport aux contacts ohmiques 40 et 48. Cette région de type n descend jusqu'au substrat 24 de type n. Les contacts ohmiques 40 et 48 servent de masque à cette hydrogénation.

Cette hydrogénation permet la formation de la région 37a de type n par neutralisation des ions donneurs de la région latérale 37 de type n$^+$. La partie de la région latérale 37 située en-dessous du contact ohmique 48 constitue la région de type n$^+$ 37b de la diode p$^+$nn$^+$.

Le procédé décrit ci-dessus en référence aux figures 3 à 7 n'est utilisable que pour des contacts 40 et 48 en matériau réfractaire, c'est-à-dire en des matériaux ne subissant aucun dommage lors du dernier recuit à 800°C de la structure.

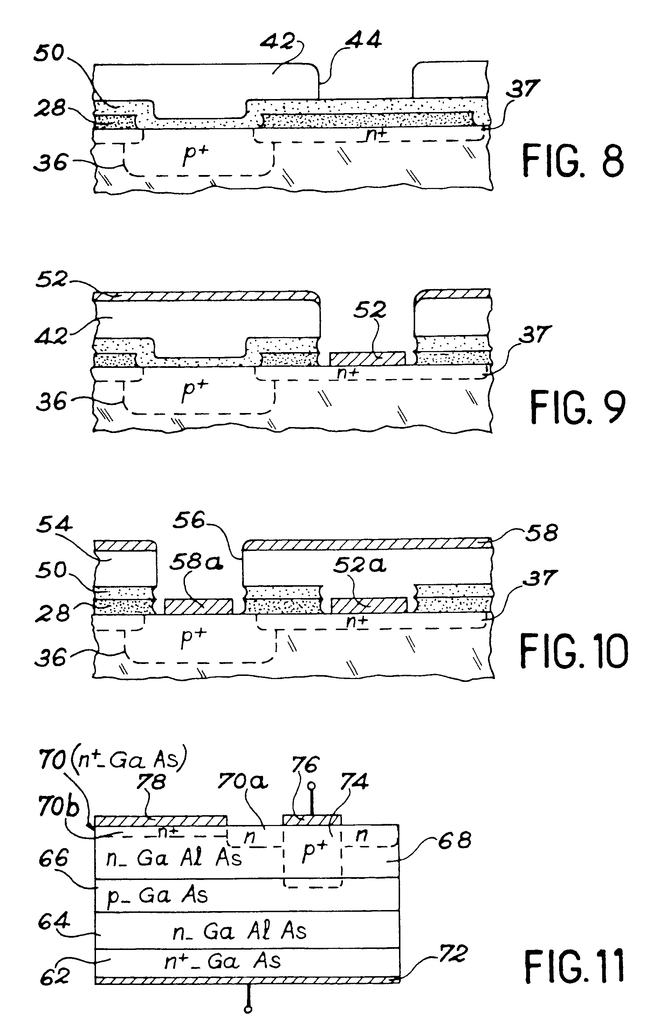

Pour la réalisation de contacts métalliques non réfractaires, on préfère utiliser la variante du procédé de l'invention représentée sur les figures 8 à 10.

Cette variante se distingue du procédé décrit précédemment par l'élimination du masque de résine 30 après formation de la région 36 de type p$^+$ de la diode, par implantation d'ions accepteurs dans le substrat 24 et la couche de type n$^+$ 26.

Après élimination du masque de résine 30, on dépose sur la structure obtenue, et en particulier sur la couche isolante 28 et sur la région 36 implantée, une autre couche d'isolant 50, comme représenté sur la figure 8, par la technique de dépôt chimique en phase vapeur assistée plasma, ayant une épaisseur de 200 nm environ. Cette couche isolante est réalisée en Si$_3$N$_4$ ou SiO$_2$.

On effectue ensuite un recuit thermique de la structure à une température de 800°C pendant environ 30 minutes sous atmosphère d'arsine en vue d'activer électriquement les ions accepteurs implantés lors de la formation de la région 36.

On forme alors le second masque de résine 42 ayant une ouverture correspondant à la région de type n$^+$ de la diode à réaliser. Le masque 42 est formé par les procédés classiques de photolithographie.

Ensuite, on élimine les régions des couches isolantes 28 et 50 non recouvertes par le masque de résine 42. Ceci est réalisé par une gravure isotrope par exemple par attaque chimique avec une solution tamponnée de HF. La structure obtenue est celle représentée sur la figure 9.

Sur le masque 42 et sur la région de type n$^+$ de la diode à réaliser, on dépose ensuite par évaporation sous vide, une couche conductrice 52 réalisée en matériau non réfractaire. Cette couche 42 est par exemple réalisée en un matériau tricouche d'or, de germanium et de nickel. Elle présente une épaisseur de l'ordre de 300 nm.

On élimine ensuite le masque de résine 42, par dissolution dans une cétone, afin de conduire par "lift off" au contact métallique 52a de la région de type n$^+$ de la diode réaliser, comme représenté sur la figure 10.

Sur la structure obtenue, on forme alors un troisième masque de résine 54 identique au premier masque 30 (figure 3) ayant une ouverture 56 correspondant à l'image du contact métallique de la région 36 implantée, à réaliser. Il est réalisé par les procédés classiques de photolithographie.

On réalise ensuite une gravure de la couche isolante 50 consistant à éliminer la région de cette couche non masquée par la résine 54. Cette gravure est réalisée de façon isotrope par attaque chimique en utilisant une solution de HF par exemple.

Puis on dépose une deuxième couche métallique 58 sur l'ensemble de la structure, et en particulier sur le masque de résine 54 et sur la région 36 de type p⁺. Cette couche 58 réalisée en matériau non réfractaire tel qu'un matériau bicouche d'or et de manganèse est déposée par évaporation sous vide. Cette couche présente une épaisseur de 300 nm environ.

On élimine ensuite le masque de résine 54, par dissolution dans une cétone, entraînant l'élimination de la seconde couche métallique à l'exception du contact métallique 58a de la région 36 de type p⁺ de la diode, par "lift off".

On effectue alors un recuit thermique de la structure pendant environ 3 minutes à 400°C afin de former les alliages des contacts métalliques 52a et 58a. En particulier, le contact métallique 58a de la région de type p⁺ est en AuMn et celui de la région de type n⁺ en AuGeNi.

Les dernières étapes de fabrication de la diode consistant à éliminer le restant des couches isolantes 28 et 50 et à hydrogéner la structure pour former la région de type n sont identiques à celles décrites précédemment en référence à la figure 7.

Sur la figure 11, on a représenté schématiquement un transistor bipolaire à hétérojonction dont l'émetteur comporte une diode p⁺nn⁺ réalisée comme décrit précédemment en référence aux figures 3 à 10.

Ce transistor comporte plusieurs couches épitaxiées par jet moléculaire ou en phase vapeur sur un substrat semi-conducteur 62 en GaAs de type n⁺, référencées en partant du substrat 64, 66, 68 et 70.

La couche 64 en $Ga_{1-x}Al_xAs$ avec $0<x\leq1$, de type n constitue le collecteur du transistor. Cette couche réalisée par exemple en $Ga_{0,6}Al_{0,4}As$ présente une épaisseur de 2 à 4 μm. Le contact métallique du collecteur 64 est réalisé par la couche conductrice 72, notamment en AuGeNi de 500 nm.

La couche 66 en GaAs de type p constitue la base du transistor bipolaire. Elle présente une épaisseur de 300 nm et est surmontée de la couche 68 en $Ga_{1-x}Al_xAs$ de type n constituant l'émetteur du transistor. Cette couche 68 présente par exemple une épaisseur de 1 μm et est réalisée en $Ga_{0,6}Al_{0,4}As$. La couche 70 est réalisée en GaAs de type n⁺ et permet la prise de contact sur l'émetteur 68. Elle mesure 700 nm environ.

Conformément à l'invention (figure 3), on réalise dans les couches 68 et 70 une région 74 implantée de type p⁺, descendant jusqu'à la base 66 du transistor. Cette région 74 qui sert de prise de contact à la base du transistor est formée en implantant des ions Mg⁺ à une dose de $10^{15}at/cm^2$ et une énergie de 400 keV (ou de béryllium) afin que cette région 74 p⁺ ait une profondeur de l'ordre de 1,8 μm.

Comme décrit précédemment (figures 4, 5 ou 10), on réalise ensuite sur cette région 74 le contact ohmique de la base 76. Ce contact de 300 nm environ est formé en particulier en AuMn.

Les étapes suivantes consistent à réaliser, comme décrit aux figures 6 à 9, la région de type n 70a et la région 70b de type n⁺ de la diode p⁺nn⁺ dans la couche 70 servant de prise de contact pour l'émetteur du transistor. Parallèlement (figures 6 et 9), on forme le contact ohmique 78 de la région 70b de type n⁺ de l'émetteur du transistor. Ce contact présente une épaisseur de 300 nm et est réalisé notamment en AuGeNi.

La description donnée précédemment n'a bien entendu été donnée qu'à titre illustratif, toutes modifications, sans pour autant sortir du cadre de l'invention, pouvant être envisagées. En particulier, l'épaisseur, le dopage et la composition des différentes couches semi-conductrices de la diode et/ou du transistor bipolaire peuvent être modifiés.

## Revendications

1. Procédé de fabrication d'une diode p⁺nn⁺ dans un substrat (24, 68) semi-conducteur en matériau III-V, comportant une région (36) de type p⁺, une région (37a) de type n et une région (37b) de type n⁺, caractérisé en ce qu'il comprend les étapes suivantes :
   – formation d'une couche (26, 70) en matériau III-V de type n⁺ à la surface du substrat (24, 68),
   – implantation locale d'ions accepteurs dans la couche (26, 70) en matériau III-V pour former, en surface, la région de type p⁺ (36, 74) de la diode adjacente à une région latérale de type n⁺ (37) de la couche de type n⁺ (26, 70),
   – réalisation de deux contacts métalliques (40, 48, 52a, 58a, 76, 78) à la surface de la couche en matériau III-V (26, 70), situés à proximité l'un de l'autre et respectivement sur la région de type p⁺ (36, 74) et sur la région latérale de type n⁺ (37), une partie (37a) de cette région latérale, contiguë à la région de type p⁺ (36, 74), étant dépourvue de contact métallique et l'autre partie (37b, 70b) de cette région latérale (37), revêtue d'un des contacts métalliques (48, 52a, 78), correspondant à la région de type n⁺ de la diode, et
   – hydrogénation (49) de la structure pour former la région de type n (37a, 70a) dans la partie de la région latérale, dépourvue de contact métallique, les contacts métalliques (40, 48, 52a, 58a, 76, 78) servant de masque à cette hydrogénation.

2. Procédé selon la revendication 1, caractérisé en ce que l'hydrogénation est réalisée en soumettant la structure à un plasma d'hydrogène.

3. Procédé selon la revendication 1 ou 2, caractérisé en ce qu'il comprend les étapes successives suivantes :
   – formation de la couche (26, 70) en matériau III-V de type n⁺
   – dépôt d'une couche isolante (28) sur la couche en matériau III-V,
   – formation d'un premier masque (30) en résine sur la couche isolante (28), ayant une ouverture correspondant à la région de type p+ (36, 74) de la diode, à réaliser,

– élimination des régions de la couche isolante (28) non masquées par le premier masque (30),

– implantation d'ions accepteurs dans la couche en matériau III-V, utilisant le premier masque (30) de résine, pour former la région de type p+ (36, 74) de la diode,

– dépôt d'une première couche métallique (38) sur le premier masque de résine (30) et sur la région de type p+ (36, 74),

– élimination du premier masque de résine (30) entraînant l'élimination de la première couche métallique (38) à l'exception du contact métallique (40, 76) de la région de type p+ (36, 74) de la diode,

– formation d'un second masque (42) en résine sur la structure obtenue, ayant une ouverture correspondant à la région de type n+ (37b, 70b) de la diode, à réaliser,

– élimination de la région de la couche isolante (28) non masquée par le second masque (42),

– dépôt d'une seconde couche métallique (46) sur le second masque de résine (42) et sur la couche de type n+ non recouverte par la couche isolante (28),

– élimination du second masque de résine (42) entraînant l'élimination de la seconde couche métallique à l'exception du contact métallique (48, 78) de la région de type n+ (37b, 70b) de la diode, à réaliser,

– recuit de la structure,

– élimination du restant de la couche isolante (28), et

– hydrogénation (49) de la structure pour former la région de type n (37a, 70a) de la diode entre les régions de type p+ (36, 74) et de type n+ (37b, 70b) de la diode.

4. Procédé selon la revendication 1 ou 2, caractérisé en ce qu'il comprend les étapes suivantes :

– formation de la couche (26, 70) en matériau III-V de type n+,

– dépôt d'une première couche isolante (28) sur la couche en matériau III-V,

– formation d'un premier masque (30) en résine sur la première couche isolante (28), ayant une ouverture correspondant à la région de type p+ (36, 74) de la diode, à réaliser,

– élimination des régions de la première couche isolante (28) non masquées par le premier masque (30),

– implantation d'ions accepteurs dans la couche en matériau III-V, utilisant le premier masque (30) de résine pour former la région de type p+ (36, 74) de la diode,

– élimination du premier masque de résine (30),

– dépôt d'une seconde couche isolante (50) sur la structure obtenue,

– recuit de la structure pour activer électriquement les ions accepteurs implantés,

– formation d'un second masque (42) sur la structure, ayant une ouverture correspondant à la région de type n+ (37b, 70b) de la diode, à réaliser,

– élimination des régions de la première (28) et de la seconde (50) couches isolantes non masquées par le second masque (42),

– dépôt d'une première couche métallique (52) sur le second masque de résine (42) et sur la couche de type n+ non recouverte par les couches isolantes (28, 50),

– élimination du second masque de résine (42) entraînant l'élimination de la première couche métallique (52) à l'exception du contact métallique (52a, 70) de la région de type n+ (37b, 70b) de la diode, à réaliser,

– dépôt d'un troisième masque (54) sur la structure, identique au premier masque (30),

– élimination de la région de la seconde (50) couche isolante non masquée par le troisième masque (54),

– dépôt d'une seconde couche métallique (58) sur la structure obtenue,

– élimination du troisième masque de résine (54) entraînant l'élimination de la seconde couche métallique à l'exception du contact métallique (58a, 76) de la région de type p+ (36, 74) de la diode,

– recuit de la structure,

– élimination des restants de la première (28) et de la seconde (50) couches isolantes, et

– hydrogénation (49) de la structure pour former la région de type n (37a, 70a) de la diode entre les régions de type p+ (36, 74) et de type n+ (37b, 70b) de la diode.

5. Procédé selon l'une quelconque des revendications 1 à 4, caractérisé en ce que le substrat et/ou la couche en matériau III-V sont formés en GaAs, InP, $Ga_{1-x}Al_xAs$, ou $Ga_{1-x}In_xAs$, avec $0 < x \le 1$.

6. Procédé selon l'une quelconque des revendications 1 à 5, caractérisé en ce que la couche (26, 70) en matériau III-V de type n+ présente une épaisseur au plus égale à 1 micromètre.

7. Procédé selon l'une quelconque des revendications 1 à 6, caractérisé en ce que la couche (26, 70) en matériau III-V de type n+ est formée par épitaxie par jet moléculaire ou en phase vapeur.

8. Procédé selon l'une quelconque des revendications 1 à 6, caractérisé en ce que la couche (26, 70) en matériau III-V de type n+ est formée en implantant des ions donneurs à la surface du substrat (24), cette implantation ionique étant suivie d'un recuit.

9. Procédé de fabrication d'un transistor bipolaire en matériau III-V comportant une diode p+nn+ entre la base et l'émetteur, caractérisé en ce qu'il comprend les étapes suivantes :

– dépôt d'une première couche (64) en matériau III-V de type n sur un substrat en matériau III-V (62), constituant le collecteur du transistor,

– dépôt d'une seconde couche (66) en matériau III-V de type p sur la première couche (64) en matériau III-V, constituant la base du transistor,

– dépôt d'une troisième couche (68) en matériau III-V de type n sur la seconde couche (66) en matériau III-V, constituant l'émetteur du transistor,

– formation d'une quatrième couche (70) en matériau III-V de type $n^+$ à la surface de la troisième couche (68) en matériau III-V, servant de contact électrique à l'émetteur,

– implantation locale d'ions accepteurs dans les quatrième (70) et troisième (68) couches en matériau III-V pour former la région de type $p^+$ (74) de la diode, adjacente à une région latérale de type $n^+$ de la quatrième couche (70), et s'étendant en profondeur jusqu'à la seconde couche (66) en matériau III-V,

– réalisation de deux contacts métalliques (76, 78) à la surface de la quatrième couche (70) en matériau III-V, situés proximité l'un de l'autre et respectivement sur la région de type $p^+$ (74) et sur la région latérale, de type $n^+$, une partie (70a) de cette région latérale, contiguë à la région de type $p^+$ (74), étant dépourvue de contact métallique et l'autre partie (70b) de cette région latérale, revêtue d'un contact métallique (78), correspondant à la région de type $n^+$ de la diode, et

– hydrogénation (49) de la structure pour former une région de type n (70a) dans la partie de la région latérale dépourvue de contact métallique, les contacts métalliques (76, 78) servant de masque à cette hydrogénation.


**Ansprüche**

1. Verfahren zum Herstellen einer $p^+nn^+$-Diode in einem halbleitenden III-V-Material mit einem $p^+$-Bereich (36), einem n-Bereich (37a) und einem $n^+$-Bereich (37b), dadurch gekennzeichnet, daß es folgende Verfahrensschritte aufweist :

– Bilden einer Schicht (26, 70) aus einem III-V-Material des $n^+$-Typs auf der Oberfläche des Substrats (24, 68),

– lokale Implantation von Akzeptorionen in der Schicht (26, 70) aus III-V-Material, um auf der Oberfläche den $p^+$-Bereich (36, 74) der Diode angrenzend an einen seitlichen Bereich des $n^+$-Typs (37) der Schicht des $n^+$-Typs (26, 70) zu bilden,

– Herstellen von zwei Metallkontakten (40, 48, 52a, 58a, 76, 78) an der Oberfläche der Schicht aus dem III-V-Material (26, 70), die nahe beieinander und jeweils auf dem $p^+$-Bereich (36, 74) und auf dem seitlichen $n^+$-Bereich (37) angeordnet sind, wobei ein Teil (37a) dieses seitlichen, an den $p^+$-Bereich (36, 74) angrenzenden Bereichs nicht mit einem metallischen Kontakt versehen ist und der andere Teil (37b, 70b) dieses seitlichen Bereichs (37), der mit einem der metallischen Kontakte (48, 52a, 78) bedeckt ist, dem Bereich des $n^+$-Typs der Diode entspricht, und

– Hydrogenisierung (49) der Struktur, um den Bereich des n-Typs (37a, 70a) in dem nicht mit einem metallischen Kontakt versehenen Teil des seitlichen Bereichs zu Bilden, wobei die metallischen Kontakte (48, 52a, 58a, 76, 78) als Maske für diese Hydrogenisierung dienen.

2. Verfahren nach Anspruch 1, dadurch gekennzeichnet, daß die Hydrogenisierung durchgeführt wird, indem die Struktur einem Wasserstoffplasma unterworfen wird.

3. Verfahren nach Anspruch 1 oder 2, dadurch gekennzeichnet, daß es die folgenden Verfahrensschritte aufweist :

– Bilden der Schicht (26, 70) aus einem III-V-Materials des $n^+$-Typs,

– Abscheiden einer isolierenden Schicht (28) auf der Schicht aus III-V-Material,

– Bilden einer ersten Maske (30) aus Photolack auf der isolierenden Schicht (28) mit einer dem Bereich des $p^+$-Typs (36, 74) der herzustellenden Diode entsprechenden Öffnung,

– Entfernen von nicht von der ersten Maske (30) maskierten Bereichen der isolierenden Schicht (28),

– Implantation von Akzeptorionen in die Schicht aus III-V-Material unter Verwendung der ersten Photolackmaske (30), um den Bereich des $p^+$-Typs (36, 74) der Diode herzustellen,

– Abscheiden einer ersten metallischen Schicht (38) auf der ersten Photolackmaske (30) und auf dem $p^+$-Bereich (36, 74),

– Entfernen der ersten Photolackmaske (30), was das Entfernen der ersten metallischen Schicht (38) mit Ausnahme des metallischen Kontakts (40, 76) des $p^+$-Bereichs (36, 74) der Diode nach sich zieht,

– Bilden einer zweiten Photolackmaske (42) auf der erhaltenen Struktur mit einer dem Bereich des $n^+$-Typs (37b, 70b) der herzustellenden Diode entsprechenden öffnung,

– Entfernen von nicht von der zweiten Maske (42) maskierten Bereichen der Isolierenden Schicht (28),

– Abscheiden einer zweiten metallischen Schicht (46) auf der zweiten Photolackmaske (42) und auf dem nicht mit der isolierenden Schicht bedeckten $n^+$-Bereich (37b 70b),

– Entfernen der zweiten Photolackmaske (42), was das Entfernen der zweiten metallischen Schicht mit Ausnahme des metallischen Kontakts (48, 78) des n⁺ -Bereichs (37b, 70b) der herzustellenden Diode nach sich zieht,

– Tempern der Struktur,

– Entfernen der verbleibenden, isolierenden Schicht (28), und

– Hydrogenisierung (49) der Struktur, um den Bereich des n-Typs (37a, 70a) der Diode zwischen den Bereichen des p⁺ -Typs (36, 74) und des n⁺ -Typs (37b, 70b) zu bilden.

4. Verfahren nach Anspruch 1 oder 2, dadurch gekennzeichnet, daß es die folgenden Verfahrensschritte aufweist :

– Bilden der Schicht (26, 70) aus einem III-V-Materials des n⁺ -Typs,

– Abscheiden einer isolierenden Schicht (28) auf der Schicht aus III-V-Material,

– Bilden einer ersten Maske (30) aus Photolack auf der isolierenden Schicht (28) mit einer dem Bereich des p⁺ -Typs (36, 74) der herzustellenden Diode entsprechenden Öffnung,

– Entfernen von nicht von der ersten Maske (30) maskierten Bereichen der isolierenden Schicht (28),

– Implantation von Akzeptorionen in die Schicht aus III-V-Material unter Verwendung der ersten Photolackmaske (30), um den Bereich des p⁺ - Typs (36, 74) der Diode herzustellen,

– Entfernen der ersten Photolackmaske (30),

– Abscheiden einer zweiten Isolierenden Schicht (50) auf der erhaltenen Struktur,

– Tempern der Struktur, um die implantierten Akzeptorionen elektrisch zu aktivieren,

– Bilden einer zweiten Photolackmaske (42) auf der erhaltenen Struktur mit einer dem Bereich des n⁺ -Typs (37b, 70b) der herzustellenden Diode entsprechenden Öffnung,

– Entfernen von nicht von der zweiten Maske (42) maskierten Bereichen der ersten (28) und zweiten (50) isolierenden Schicht,

– Abscheiden einer ersten metallischen Schicht (52) auf der zweiten Photolackmaske (42) und auf dem nicht mit der ersten (28) und zweiten (50) isolierenden Schicht bedeckten n⁺-Schicht,

– Entfernen der zweiten Photolackmaske (42), was das Entfernen der ersten metallischen Schicht (52) mit Ausnahme des metallischen Kontakts (52a, 70) des n⁺ -Bereichs (37b, 70b) der herzustellenden Diode nach sich zieht,

– Abscheiden einer dritten Maske (54) auf der Struktur, die der ersten Maske (30) identisch ist,

– Entfernen des Bereichs der zweiten isolierenden Schicht (50), der nicht von der dritten Maske (54) maskiert wird,

– Abscheiden einer zweiten metallischen Schicht (58) auf der erhaltenen Struktur,

– Entfernen der dritten Photolackmaske (54), was das Entfernen der zweiten metallischen Schicht außer des metallischen Kontakts (58a, 76) des p⁺ -Bereichs (36, 74) nach sich zieht,

– Tempern der Struktur,

– Entfernen der Reste der ersten (28) und zweiten (50) Isolierenden Schicht, und

– Hydrogenisierung (49) der Struktur, um den Bereich des n-Typs (37a, 70a) der Diode zwischen den Bereichen des p⁺ -Typs (36, 74) und des n⁺ -Typs (37b, 70b) zu bilden.

5. Verfahren nach einem der Ansprüche 1 bis 4, dadurch gekennzeichnet, daß das Substrat und/oder die Schicht aus III-V-Material aus GaAs, InP, $Ga_{1-x}Al_xAs$ oder $Ga_{1-x}In_xAs$ mit $0<x\leq1$ besteht.

6. Verfahren nach einem der Ansprüche 1 bis 5, dadurch gekennzeichnet, daß die Schicht (26, 70) aus III-V-Material des n⁺ -Typs eine Dicke von höchstens 1 Mikrometer aufweist.

7. Verfahren nach einem der Ansprüche 1 bis 6, dadurch gekennzeichnet, daß die Schicht (26, 70) aus III-V-Material des n⁺ -Typs durch Molekularstrahl- oder Gasphasenepitaxie hergestellt wird.

8. Verfahren nach einem der Ansprüche 1 bis 6, dadurch gekennzeichnet, daß die Schicht (26, 70) aus III-V-Material des n⁺ -Typs durch Implantation von Donatorionen in die Substratoberfläche (24) hergestellt wird, wobei diese Ionenimplantation von einer Temperung gefolgt wird.

9. Verfahren zum Herstellen eines Bipolartransistors aus III-V-Material mit einer p⁺nn⁺ -Diode zwischen der Basis und dem Emitter, dadurch gekennzeichnet, daß es folgende Verfahrensschritte aufweist :

– Abscheiden einer ersten Schicht (64) aus III-V-Material des n-Typs auf einem Substrat aus III-V-Material (62), die den Kollektor des Transistors bildet,

– Abscheiden einer zweiten Schicht (66) aus III-V-Material des p-Typs auf der ersten Schicht aus III-V-Material (64), die die Basis des Transistors bildet,

– Abscheiden einer dritten Schicht (68) aus III-V-Material des n-Typs auf der zweiten Schicht aus III-V-Material (66), die den Emitter des Transistors bildet,

– Herstellen einer vierten Schicht (70) aus III-V-Material des n⁺-Typs auf der dritten Schicht aus III-V-Material (68), die als elektrischer Kontakt für den Emitter dient,

– lokale Implantation von Akzeptorionen in die vierte (70) und dritte Schicht (68) aus III-V-Material, um den p⁺ -Bereich (74) der Diode zu bilden, der an einen seitlichen Bereich des n⁺-Typs der vierten Schicht angrenzt und sich in die Tiefe bis zur zweiten Schicht (66) aus III-V-Material erstreckt,

– Herstellung von zwei metallischen Kontakten (76, 78) auf der Oberfläche der vierten Schicht (70) aus III-V-Material, die nahe beieinander und jeweils auf dem p⁺ -Bereich (74) und auf dem seitlichen n⁺-Bereich angeordnet sind, wobei ein Teil (70a) dieses seitlichen, an den p⁺ -Bereich (74) angrenzenden Bereichs nicht mit einem metallischen Kontakt versehen ist und der andere Teil (70b) dieses seitlichen Bereichs, der mit einem der metallischen Kontakte (78) bedeckt ist, dem Bereich des n⁺-Typs der Diode entspricht, und
– Hydrogenisierung (49) der Struktur, um den Bereich des n-Typs (70a) in dem nicht mit einem metallischen Kontakt versehenen Teil des seitlichen Bereichs zu Bilden, wobei die metallischen Kontakte (76, 78) als Maske für diese Hydrogenisierung dienen.

## Claims

1. Method for the production of a p⁺nn⁺ diode in a III-V material semiconductor substrate (24, 68) having a type p⁺ region (36), a type n region (37a) and a type n⁺ region (37b), characterized in that it comprises the following stages :
   – formation of a type n⁺ III-V material layer (26, 70) on the surface of the substrate (24, 68),
   – local implantation of acceptor ions in the III-V material layer (26, 70) for forming on the surface the type p⁺ region (36, 74) of the diode adjacent to the type n⁺ lateral region (37) of the type n⁺ layer (26, 70),
   – producing two metal contacts (40, 48, 52a, 58a, 76, 78) on the surface of the III-V material layer (26,70) located in the vicinity of one another and respectively on the type p⁺ region (36, 74) and on the type n⁺ lateral region (37), one portion (37a) of said lateral region contiguous with the type p⁺ region (36, 74) having no metal contact and the other portion (37b, 70b) of said lateral region (37), bearing metal contacts (48, 52a, 78), corresponding to the type n⁺ region of the diode and
   – hydrogenation (49) of the structure to form the type n region (37a, 70a) in that portion of the lateral region having no metal contact, the metal contacts (40, 48, 52a, 58a, 76, 78) serving as a mask for said hydrogenation.

2. Method according to claim 1, characterized in that hydrogenation is carried out by exposing the structure to a hydrogen plasma.

3. Method according to claims 1 or 2, characterized in that it comprises the following successive stages :
   – formation of the type n⁺, III-V material layer (26, 70),
   – deposition of an insulating layer (28) on the III-V material layer,
   – formation of a first resin mask (30) on the insulating layer (28) having an opening corresponding to the type p⁺ region (36,74) of the diode to be produced,
   – elimination of the regions of the insulating layer (28) not masked by the first mask (30),
   – implantation of acceptor ions in the III-V material layer using the first resin mask (30) for forming the type p⁺ region (36, 74) of the diode,
   – deposition of a first metal layer (38) on the first resin mask (30) and on the type p⁺ region (36, 74),
   – elimination of the first resin mask (30) leading to the elimination of the first metal layer (38) excepting the metal contact (40,76) of the type p⁺ region (36, 74) of the diode,
   – formation of a second resin mask (42) on the structure obtained having an opening corresponding to the type n⁺ region (37b, 70b) of the diode to be produced,
   – elimination of the region of the insulating layer (28) not masked by the second mask (42),
   – deposition of a second metal layer (46) on the second resin mask (42) and on the type n⁺ layer not covered by the insulating layer (28),
   – elimination of the second resin mask (42) leading to the elimination of the second metal layer excepting the metal contact (48, 78) of the type n⁺ region (37b, 70b) of the diode to be produced,
   – annealing the structure,
   – elimination of the remainder of the insulating layer (28) and
   – hydrogenation (49) of the structure to form the type n region (37a, 70a) of the diode between the type p⁺ regions (36, 74) and the type n regions (37b, 70b) of the diode.

4. Method according to claims 1 or 2, characterized in that it comprises the following stages :
   – formation of the type n⁺ III-V material layer (26,70),
   – deposition of a first insulating layer (28) on the III-V material layer,
   – formation of a first resin mask (30) on the first isulating layer having an opening corresponding to the type p⁺ region (36, 74) of the diode to be produced,
   – elimination of the regions of the first insulating layer (28) not masked by the first mask (30),
   – implantation of acceptor ions in the III-V material layer using the first resin mask (30) for forming the type p⁺ region (36, 74) of the diode,
   – elimination of the first resin mask (30),
   – deposition of a second insulating layer (50) on the structure obtained,
   – annealing the structure to electrically activate the implanted acceptor ions,
   – formation of a second ask (42) on the structure having an opening corresponding to the type n region (37b, 70b) of the diode to be produced,
   – elimination of the regions of the first (28) and second (50) insulating layers not masked by the second mask (42),
   – deposition of a first metal layer (52) on the second resin ask (42) and on the type n+ layer not covered by the insulating layers (28, 50),

– elimination of the second resin ask (42) leading to the elimination of the first metal layer (52) excepting the metal contact (52a, 70) of the type n+ region (37b, 70b) of the diode to be produced,

– deposition of a third mask (54) on the structure, which is identical to the first mask (30),

– elimination of the region of the second insulating layer (50) not masked by the third ask (54),

– deposition of a second metal layer (58) on the structure obtained,

– elimination of the third resin mask (54) leading to the elimination of the second metal layer excepting the metal contact (58a, 76) of the type p+ region (36, 74) of the diode,

– annealing the structure,

– eliminating the remainder of the first (28) and second (50) insulating layers and

– hydrogenation (49) of the structure to form the type n region (37a, 70a) of the diode between the type p+ regions (36, 74) and type n+ regions (37b, 70b) of the diode.

5. Method according to any one of the claims 1 to 4, characterized in that the substrate and/or III-V material layer are made from GaAs, InP, $Ga_{1-x}Al_xAs$, or $Ga_{1-x}In_xAs$, with $0<x\leq1$.

6. Method according to any one of the claims 1 to 5, characterized in that the type n+ III-V material layer (26, 70) has a thickness of at the most 1 micrometer.

7. Method according to any one of the claims 1 to 6, characterized in that the type n+ III-V material layer (26, 70) is formed by vapour phase or molecular jet epitaxy.

8. Method according to any one of the claims 1 to 6, characterized in that the type n+ III-V material layer (26, 70) is formed by implanting donor ions on the surface of the substrate (24), said ion implantation being followed by annealing.

9. Method for producing a III-V arterial bipolar transistor having a p+nn+ diode between the base and the emitter, characterized in that it comprises the following stages :

– deposition of a first type n III-V material layer (64) on III-V material substrate (62) constituting the collector of the transistor,

– deposition of a second type p III-V material layer (66) on the first III-V material layer (64) constituting the base of the transistor,

– deposition of a third type n III-V material layer (68) on the second III-V material layer (66) constituting the emitter of the transistor,

– formation of a fourth type n+ III-V material layer (70) on the surface of the third III-V material layer (68) serving as an electric contact for the emitter,

– local implantation of acceptor ions in the fourth (70) and third (68) III-V material layers to form he type p+ region (74) of the diode, adjacent to the type n+ lateral region of the fourth layer (70) and extending depthwise to the second III-V material layer (66),

– production of two metal contacts (76,78) on the surface of the fourth III-V material layer (70), located in the vicinity of one another and respectively on the type p+ region (74) and on the type n lateral region, one portion (70a) of said lateral region, contiguous with the type p+ region (74), having no metal contact, whilst the other portion (70b) of said lateral region and bearing a metal contact (78) corresponds to the type n+ region of the diode and

– hydrogenation (49) of the structure to form a type n region (70a) in that portion of the lateral region having no metal contact, the metal contacts (76,78) serving as a mask for said hydrogenation.

FIG. 1

FIG. 2

FIG. 3

FIG. 4

FIG. 5

FIG. 6

FIG. 7

FIG. 8

FIG. 9

FIG. 10

FIG. 11